# EUROPEAN PATENT APPLICATION

(11) **EP 4 651 178 A1**
(43) Date of publication of application: **19.11.2025**
(21) Application number: 25173658.3
(22) Date of filing: 30.04.2025
(51) Int. Cl.: H01J 43/30

(54) **ELECTRON MULTIPLIER HAVING SELF-ADJUSTING GAIN FUNCTION**

(30) Priority: 14.05.2024 GB 202406761
(71) Applicant: ADAPTAS SOLUTIONS PTY LTD, Clyde, NSW 2142 (AU)
(72) Inventor: Jones, Antony, Clyde, 2142 (AU); Ekers, Daen, Clyde, 2142 (AU); Jurek, Russell, Clyde, 2142 (AU)
(74) Representative: Range, Christopher William

(57) **Abstract**

A method for determining a performance parameter of an electron multiplier having a series of electron emissive surfaces forming electron multiplication chain, by comparing a first electron flux of a first electron emissive surface of the electron multiplication chain with a second electron flux of a second electron emissive surface of the electron multiplication chain, or of an electron collector of the electron multiplier. A method of operating an electron multiplier and an electron multiplier or an electron multiplication system is also described.

## Description

### FIELD OF THE INVENTION

.The present invention relates to generally to components of scientific analytical equipment. More particularly, the invention relates to electron multipliers of the type used to amplify an ion signal in a mass spectrometer, or to amplify light in a photomultiplier tube. The invention provides an electron multiplier and methods of operation thereof allowing for the continuous and automatic adjustment of gain to take account of reduced performance due to multiplier ageing.

### BACKGROUND TO THE INVENTION

.In a mass spectrometer, the analyte is ionized to form a range of charged particles (ions). The resultant ions are then separated according to their mass-to-charge ratio, typically by acceleration and exposure to an electric or magnetic field. The separated signal ions are directed to an electron multiplier for amplification.

.Electron multipliers generally operate by way of secondary electron emission whereby the impact of a single or multiple particles on a first multiplier electron emissive surface thereby causing multiple secondary electrons associated with atoms of the impact surface to be released. The released electrons travel to a second electron emissive surface of the multiplier, each of which triggers the release of multiple secondary electrons. The secondary electrons from the second electron emissive surface travel to a third electron emissive surface, and so on. By this arrangement, an amplification chain is established with each step of chain providing a geometric increase in electron numbers. Toward the end the amplification chain, an avalanche of electrons is generated to form a highly amplified signal. These electrons are collected by an anode, and the current so produced is measured and recorded by computer-assisted means. Results are displayed as a spectrum of the relative abundance of detected ions as a function of the mass-to-charge ratio.

.In other applications the particle to be detected may not be an ion, and may be a neutral atom, a neutral molecule, an electron, or a photon. In any event, the electron multiplier is used to amplify the particle signal.

.One type of electron multiplier is known as a discrete-dynode electron multiplier. Such multipliers include a series of surfaces called dynodes, with each dynode in the series set to increasingly more positive voltage. A voltage divider is typically implemented to distribute voltage between the dynodes. Each dynode is capable of emitting more than one electron, thereby forming a multiplication chain.

.Another type of electron multiplier operates using a single continuous dynode. In these versions, the resistive material of the continuous dynode itself is used as a voltage divider to distribute voltage along the length of the emissive surface. A continuous dynode may be a single or multiple channel device. Multi-channel devices may be constructed directly or by combining single channel continuous dynodes, for example by twisting a bundle of single channel dynodes around a common axis to create a single detector.

.A detector may comprise a microchannel plate detector, being a planar component used for detection of single particles (electrons, ions and neutrons). It is closely related to an electron multiplier, as both intensify single particles by the multiplication of electrons via secondary emission. However, because a microchannel plate detector has many separate channels, it can additionally provide spatial resolution.

.It is a problem in the art that the performance of electron emission-based detectors degrade over time. It is thought that secondary electron emission reduces over time causing the gain of the electron multiplier to decrease. To compensate for this process, the operating voltage applied to the multiplier must be periodically increased to maintain the required multiplier gain. Ultimately, however, the multiplier will require replacement.

.It is also a problem in the art that the performance of electron emission-based detectors can degrade more rapidly in gain during the initial stages of their service life. This initial gain loss is sometimes referred to as "burn-in." Prior artisans have addressed this issue by employing an initial intense period of operation so as to rapidly overcome the "burn-in" period before the instrument is used for actual analysis work. While effective, this approach takes time and effort and delays the implementation of a new detector.

. In any event, a detector user is burdened by the need to periodically manually adjust the gain of a detector so as to achieve some minimum target value. Several strategies are currently implemented to extend the time between calibrations.

. One strategy involves setting the operating gain higher than the minimum target value. The practice of using 'higher than necessary' operating gain relies on the continual decline of detector gain with use. Setting a sufficiently high initial operating gain ensures that the detector output is still above the required signal level at the end of an experiment.

. Another strategy is to design a detector with aim of extending the service life as long as possible. The goal is to slow the detector ageing rate thereby increasing the time period between gain adjustments. Detector lifetime is predicated by the service cycle of the machine. Service cycles are in the order of 1 year for machine maintenance or 7 years for machine refurbishment. Therefore, detector lifetime needs to be approximately 15 months or more than 7 years to match the service contract and refurbishment periods with a reasonable buffer. Some users require a service life in excess of 7 years, being driven by their need to achieve specific, extended workflows between calibrations. The need for extended detector life often occurs in clinical applications because the FDA and other regulatory bodies mandate the allowable gain decrease with use, calibration cycle, etc.

. Even with extended service life detectors, gain instability is still a problem for all detectors that inevitably leads to the need for the user to monitor and adjust operating gain periodically.

. Gain instability can present as a chronic or an acute problem. Chronic gain instability manifests as the slow, consistent decline in electron multiplier gain with sustained usage over many weeks, months, or years. Acute gain instability is a rapid change in gain over minutes, hours, or days. For context, a 10-fold reduction in gain during the first 90 minutes of detector operation is not uncommon.

. Gain instability drives two behaviours in end users. Firstly, users regularly adjust detector gain. Second, and as discussed above, they set a higher gain than is necessary. Both of these behaviours have negative consequences.

. Regular adjustment of detector gain requires consumables, operator time and reduces system uptime. All of these raise the 'cost per test' of the system. They also affect the total throughput of the system on large time scales.

. Moreover, setting a higher gain than is required to achieve a minimum target gain reduces the service life of the detector due to the larger electron fluxes impacting the electron emissive surfaces. Further negative consequences of setting an unnecessarily high gain arise in the loss of detector linearity, ion feedback and noise.

. It is an aspect of the present invention to overcome or ameliorate a problem of the prior art by providing an electron multiplier, that when used in the context of a particle detector, obviates or reduces the need for manual gain adjustment. The invention may also provide an electron multiplier having an extended service life, or an improvement in gain instability, response linearity, ion feedback or noise. It is a further aspect to provide a useful alternative to the prior art.

. The discussion of documents, acts, materials, devices, articles and the like is included in this specification solely for the purpose of providing a context for the present invention. It is not suggested or represented that any or all of these matters formed part of the prior art base or were common general knowledge in the field relevant to the present invention as it existed before the priority date of each claim of this application.

### SUMMARY OF THE INVENTION

. In a first aspect, but not necessarily the broadest aspect, the present invention provides a method for determining a performance parameter of an electron multiplier having a series of electron emissive surfaces forming electron multiplication chain, the method comprising comparing a first electron flux of a first electron emissive surface of the electron multiplication chain with a second electron flux of a second electron emissive surface of the electron multiplication chain, or of an electron collector of the electron multiplier.

. In one embodiment of the first aspect, the first and the second electron emissive surfaces are each a discrete electron emissive surface.

. In one embodiment of the first aspect, each of the discrete electron emissive surfaces is a dynode of a discrete dynode electron multiplier.

. In one embodiment of the first aspect, the first and the second electron emissive surfaces are provided by a single electron emissive surface.

. In one embodiment of the first aspect, the single electron emissive surface is a channel of a channel electron multiplier, or a plate of a microchannel plate electron multiplier.

. In one embodiment of the first aspect, the first electron emissive surface is earlier in the electron multiplication chain than the second electron emissive surface.

. In one embodiment of the first aspect, the first electron emissive surface is less susceptible to electron flux-mediated gain degradation than the second electron emissive surface.

. In one embodiment of the first aspect, the first electron emissive surface carries less electron flux than the second electron emissive surface.

. In one embodiment of the first aspect, the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than the second electron emissive surface.

. In one embodiment of the first aspect, the second electron flux is determined at the electron collector and the first electron emissive surface carries less electron flux than a terminal electron emissive surface of the electron multiplication chain.

. In one embodiment of the first aspect, the second electron flux is determined at the electron collector and the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than a terminal electron emissive surface of the electron multiplication chain.

. In one embodiment of the first aspect, the first electron emissive surface is within the first 75%, 70%, 65%, 60%, 55%, 50%, 45%, 40%, 35%, 30%, or 25% of the electron multiplication chain.

. In one embodiment of the first aspect, the first electron emissive surface is not within the first 5%, 10%, 15%, 20% or 25% of the electron multiplication chain.

. In one embodiment of the first aspect, the electron multiplier comprises discrete electron emissive surfaces, the first electron emissive surface is the third, fourth, fifth, sixth or seventh electron emissive surface of the electron multiplication chain.

. In one embodiment of the first aspect, the electron multiplier comprises discrete electron emissive surfaces, the first electron emissive surface is the fourth, fifth, or sixth electron emissive surface of the electron multiplication chain.

. In one embodiment of the first aspect, the electron multiplier comprises discrete electron emissive surfaces, the first electron emissive surface is the fifth electron emissive surface of the electron multiplication chain.

. In one embodiment of the first aspect, the electron multiplier comprises discrete electron emissive surfaces, the first electron emissive surface and the second electron emissive surface, or the first electron emissive surface and the electron collector, are separated by at least 2, 3, 4, or 5 intervening electron emissive surfaces.

. In one embodiment of the first aspect, the electron multiplier comprises a single electron emissive surface having a series of electron emissive sites which together form the electron multiplication chain, and the first electron emissive surface is the third, fourth, fifth, sixth or seventh electron emissive site of the electron multiplication chain.

. In one embodiment of the first aspect, the electron multiplier comprises a single electron emissive surface having a series of electron emissive sites which together form the electron multiplication chain, and the first electron emissive surface is the fourth, fifth, or sixth electron emissive site of the electron multiplication chain.

. In one embodiment of the first aspect, the electron multiplier comprises a single electron emissive surface having a series of electron emissive sites which together form the electron multiplication chain, and the first electron emissive surface is the fifth electron emissive site of the electron multiplication chain.

. In one embodiment of the first aspect, the electron multiplier comprises a single electron emissive surface having a series of electron emissive sites which together form the electron multiplication chain, the first electron emissive site and the second electron emissive site, or the first electron emissive site and the electron collector, are separated by at least 2, 3, or 4 intervening electron emissive sites.

. In one embodiment of the first aspect, the first and second electron fluxes are compared by way of (i) an electrical current measurement circuit and then comparing the determined currents, or (ii) an electrical current comparison circuit.

. In one embodiment of the first aspect, the first and second electron fluxes are each determined at the same time point, or within a time period.

. In one embodiment of the first aspect, the first and second electron fluxes are determined intermittently over a period of electron multiplier operation.

. In one embodiment of the first aspect, the period of electron multiplier operation is equal to or greater than about 1 sec, 5 sec, 10 sec, 30 sec, 1 min, 5 min, 10 min, 20 min, 30 min, 40 min, 50 min or 1 hr.

. In one embodiment of the first aspect, the first and second electron fluxes are determined according to a sampling rate.

. In one embodiment of the first aspect, the sampling rate is equal to or less than about 1 Hz, 0.1 Hz or about 0.01 Hz.

. In one embodiment of the first aspect, the sampling rate is equal to or greater than about 0.1 Hz, 0.2 Hz, 0.3 Hz, 0.4 Hz, 0.5 Hz, 0.6 Hz, 0.7 Hz, 0.8 Hz, 0.9 Hz, or 1 Hz.

. In one embodiment of the first aspect, the sampling rate is between about 0.3 Hz and 0.01 Hz.

. In one embodiment of the first aspect, the performance parameter is indicative of gain of the electron multiplier.

. In one embodiment of the first aspect, the step of comparing comprises a mathematical operation utilising the determined first and second electron fluxes.

. In one embodiment of the first aspect, the mathematical operation comprises the generation of a ratio, a multiple, a quotient, or a difference.

. In a second aspect, the present invention provides a method of operating an electron multiplier, the method comprising: determining a performance parameter of the electron multiplier according to the method of any embodiment of the first aspect, comparing the determined performance parameter to a predetermined value or a predetermined range for the performance parameter, and where the determined performance parameter is not the predetermined value or is outside the predetermined range for the performance parameter, altering an operating parameter of the electron multiplier such that the determined performance parameter is the predetermined value or is inside the predetermined range for the performance parameter.

. In one embodiment of the second aspect, the operating parameter is a voltage bias applied to the electron multiplier.

. In one embodiment of the second aspect, the method is implemented so as to continuously monitor the performance parameter and as required alter the operating parameter of the electron multiplier, wherein the steps of determining, comparing and altering are sequentially executed multiple times over a time period.

. In one embodiment of the second aspect, the performance parameter is electron multiplier gain, and the gain of the electron multiplier is maintained at a predetermined gain or with a predetermined gain range over a time period.

. In a third aspect, the present invention provides an electron multiplier or electron multiplication system having a series of electron emissive surfaces forming electron multiplication chain, the electron multiplier method comprising circuitry and optionally processor-executable program instructions configured to compare a first electron flux of a first electron emissive surface of the electron multiplication chain with a second electron flux of a second electron emissive surface of the electron multiplication chain, or of an electron collector of the electron multiplier.

. In one embodiment of third aspect, the first and the second electron emissive surfaces are each a discrete electron emissive surface.

. In one embodiment of third aspect, each of the discrete electron emissive surfaces is a dynode of a discrete dynode electron multiplier.

. In one embodiment of third aspect, the first and the second electron emissive surfaces are provided by a single electron emissive surface.

. In one embodiment of third aspect, the single electron emissive surface is a channel of a channel electron multiplier, or a plate of a microchannel plate electron multiplier.

. In one embodiment of third aspect, the first electron emissive surface is earlier in the electron multiplication chain than the second electron emissive surface.

. In one embodiment of third aspect, the first electron emissive surface is less susceptible to electron flux-mediated gain degradation than the second electron emissive surface.

. In one embodiment of third aspect, the first electron emissive surface carries less electron flux than the second electron emissive surface.

. In one embodiment of third aspect, the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than the second electron emissive surface.

. In one embodiment of third aspect, the second electron flux is determined at the electron collector and the first electron emissive surface carries less electron flux than a terminal electron emissive surface of the electron multiplication chain.

. In one embodiment of third aspect, the second electron flux is determined at the electron collector and the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than a terminal electron emissive surface of the electron multiplication chain.

. In one embodiment of third aspect, the first electron emissive surface is within the first 75%, 70%, 65%, 60%, 55%, 50%, 45%, 40%, 35%, 30%, or 25% of the electron multiplication chain.

. In one embodiment of third aspect, the first electron emissive surface is not within the first 5%, 10%, 15%, 20% or 25% of the electron multiplication chain.

. In one embodiment of third aspect, the electron multiplier comprises discrete electron emissive surfaces, the first electron emissive surface is the third, fourth, fifth, sixth or seventh electron emissive surface of the electron multiplication chain.

. In one embodiment of third aspect, the electron multiplier comprises discrete electron emissive surfaces, the first electron emissive surface is the fourth, fifth, or sixth electron emissive surface of the electron multiplication chain.

. In one embodiment of third aspect, the electron multiplier comprises discrete electron emissive surfaces, the first electron emissive surface is the fifth electron emissive surface of the electron multiplication chain.

. In one embodiment of third aspect, the electron multiplier comprises discrete electron emissive surfaces, the first electron emissive surface and the second electron emissive surface, or the first electron emissive surface and the electron collector, are separated by at least 2, 3, 4, or 5 intervening electron emissive surfaces.

. In one embodiment of third aspect, the electron multiplier comprises a single electron emissive surface having a series of electron emissive sites which together form the electron multiplication chain, and the first electron emissive surface is the third, fourth, fifth, sixth or seventh electron emissive site of the electron multiplication chain.

. In one embodiment of third aspect, the electron multiplier comprises a single electron emissive surface having a series of electron emissive sites which together form the electron multiplication chain, and the first electron emissive surface is the fourth, fifth, or sixth electron emissive site of the electron multiplication chain.

. In one embodiment of third aspect, the electron multiplier comprises a single electron emissive surface having a series of electron emissive sites which together form the electron multiplication chain, and the first electron emissive surface is the fifth electron emissive site of the electron multiplication chain.

. In one embodiment of third aspect, the electron multiplier comprises a single electron emissive surface having a series of electron emissive sites which together form the electron multiplication chain, the first electron emissive site and the second electron emissive site, or the first electron emissive site and the electron collector, are separated by at least 2, 3, or 4 intervening electron emissive sites.

. In one embodiment of third aspect, the circuitry and optionally the program instructions compares the first and second electron fluxes at least in part by (i) an electrical current measurement circuit and then comparing the measured currents by way of the program instructions, or (ii) an electrical current comparison circuit.

. In one embodiment of third aspect, the circuitry and optionally the program instructions is/are configured to determine the first and second electron fluxes at the same time point, or within a time period.

. In one embodiment of third aspect, the circuitry and optionally the program instructions is/are configured to determine first and second electron fluxes are determined intermittently over a period of electron multiplier operation.

. In one embodiment of third aspect, the period of electron multiplier operation is equal to or greater than about 1 sec, 5 sec, 10 sec, 30 sec, 1 min, 5 min, 10 min, 20 min, 30 min, 40 min, 50 min or 1 hr.

. In one embodiment of third aspect, the circuitry and optionally the program instructions is/are configured such that the first and second electron fluxes are determined according to a sampling rate.

. In one embodiment of third aspect, the sampling rate is equal to or less than about 1 Hz, 0.1 Hz or about 0.01 Hz.

. In one embodiment of third aspect, the sampling rate is equal to or greater than about 0.1 Hz, 0.2 Hz, 0.3 Hz, 0.4 Hz, 0.5 Hz, 0.6 Hz, 0.7 Hz, 0.8 Hz, 0.9 Hz, or 1 Hz.

. In one embodiment of third aspect, the sampling rate is between about 0.3 Hz and 0.01 Hz.

. In one embodiment of third aspect, the performance parameter is indicative of a gain of the electron multiplier.

. In one embodiment of the third aspect, the circuitry and optionally program instructions is/are configured to: determine a performance parameter of the electron multiplier, compare the determined performance parameter to a predetermined value or a predetermined range for the performance parameter, and where the determined performance parameter is not the predetermined value or is outside the predetermined range for the performance parameter, alter an operating parameter of the electron multiplier such that the determined performance parameter is the predetermined value or is inside the predetermined range for the performance parameter.

. In one embodiment of the third aspect, the operating parameter is a voltage bias applied to the electron multiplier.

. In one embodiment of the third aspect, the circuitry and optionally the program instructions is/are configured to continuously monitor the performance parameter and as required alter the operating parameter of the electron multiplier, wherein the steps of determining, comparing and altering are sequentially executed multiple times over a time period.

. In one embodiment of the third aspect, the performance parameter is electron multiplier gain, and the gain of the electron multiplier is maintained at a predetermined gain or with a predetermined gain range over a time period.

### BRIEF DESCRIPTION OF THE DRAWINGS

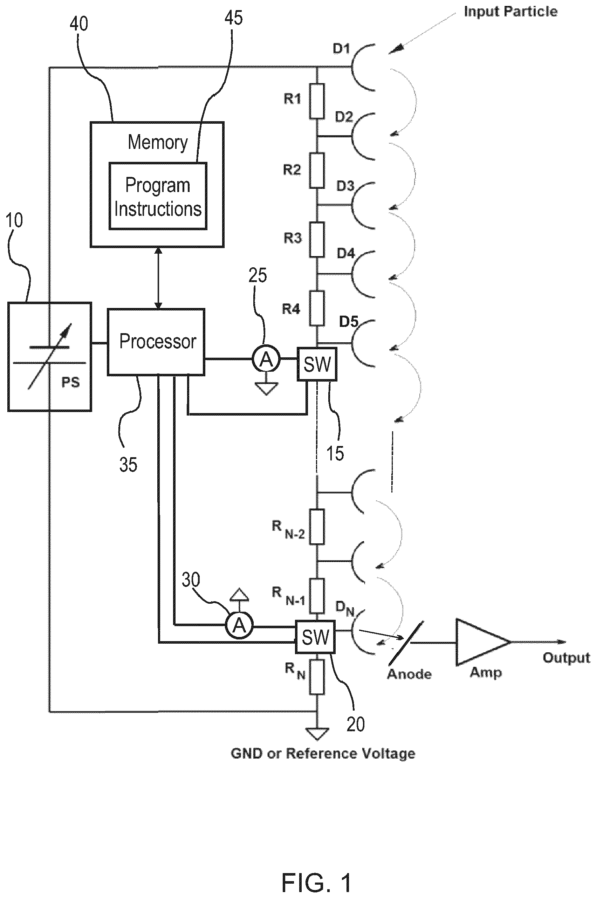

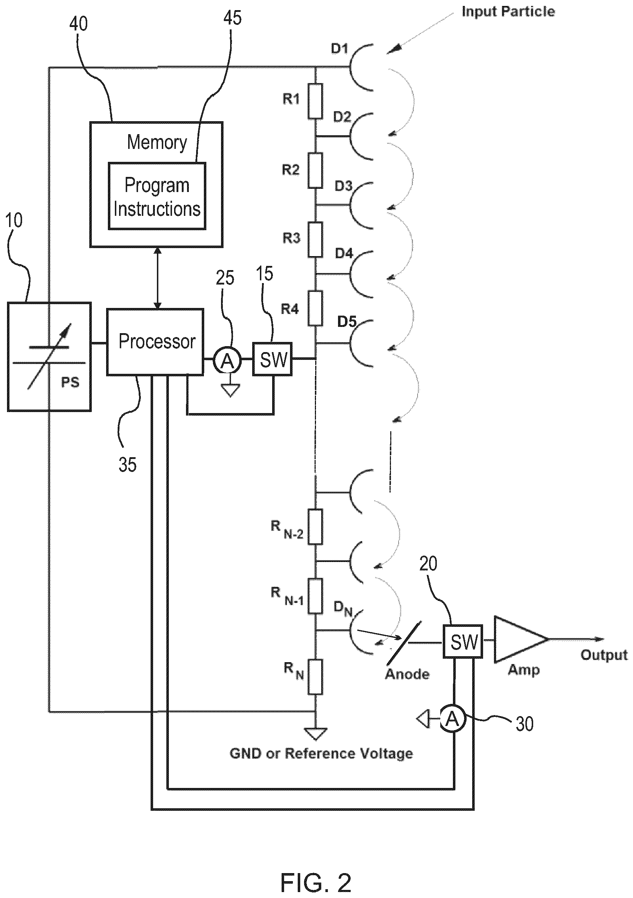

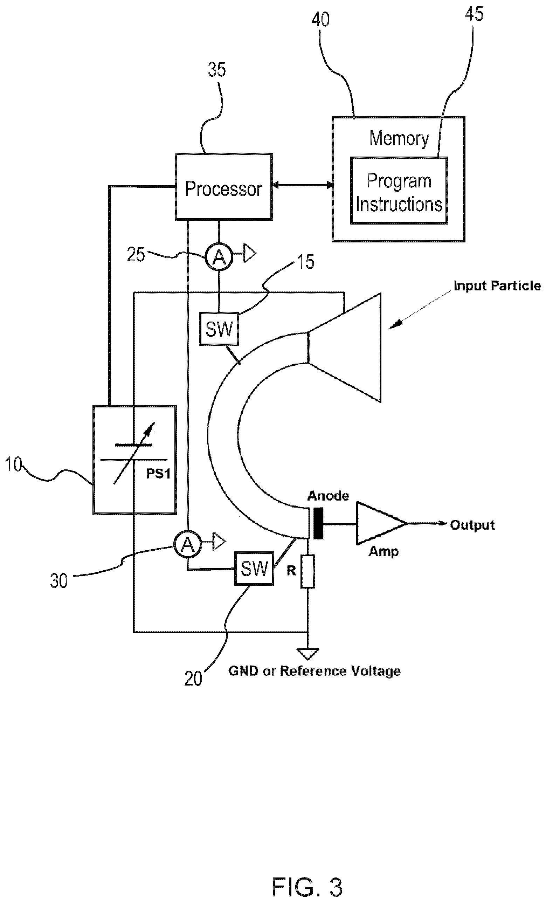

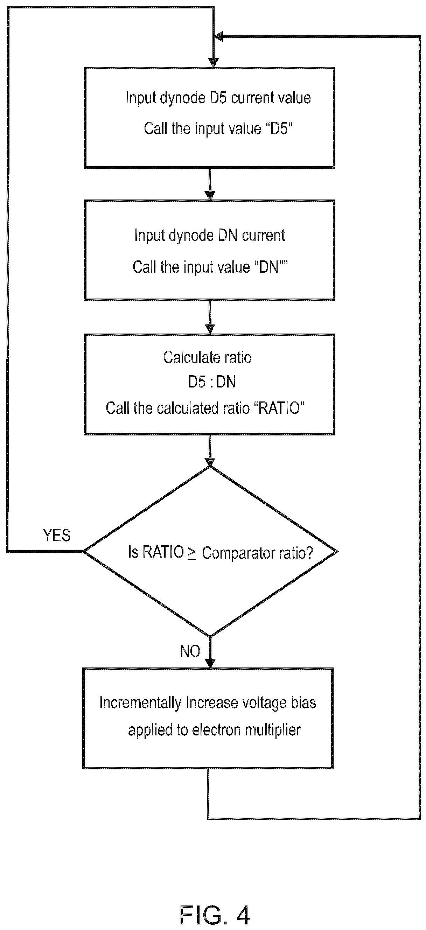

. FIG. 1 is a diagrammatic representation of a discrete dynode electron multiplier of the present invention. Currents of two dynodes (D5 and D_{N}) are used to determine a current ratio.
. FIG. 2 is a diagrammatic representation of a discrete dynode electron multiplier of the present invention. Currents of one dynodes (D5) and the collector anode are used to determine a current ratio.
. FIG. 3 a diagrammatic representation of a channel electron multiplier of the present invention. Currents of an early site and a later site along the electron multiplication chain are used to determine a current ratio.
. FIG. 4 is a flow diagram of an algorithm used in program instructions to adjust, if necessary, the gain of the electron multiplier.

### DETAILED DESCRIPTION OF THE INVENTION INCLUDING ILLUSTRATIVE EMBODIMENTS THEREOF

. After considering this description it will be apparent to one skilled in the art how the invention is implemented in various alternative embodiments and alternative applications. However, although various embodiments of the present invention will be described herein, it is understood that these embodiments are presented by way of example only, and not limitation. As such, this description of various alternative embodiments should not be construed to limit the scope or breadth of the present invention. Furthermore, statements of advantages or other aspects apply to specific exemplary embodiments, and not necessarily to all embodiments covered by the claims.

. Throughout the description and the claims of this specification the word "comprise" and variations of the word, such as "comprising" and "comprises" is not intended to exclude other additives, components, integers or steps.

. Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

. It will be appreciated that not all embodiments of the invention described herein have all of the advantages disclosed herein. Some embodiments may have a single advantage, while others may have no advantage at all and are merely a useful alternative to the prior art.

. The present invention is predicated at least in part on the discovery that the gain of an electron multiplier can be continuously and automatically adjusted to account for gain instability (whether chronic or acute) such that the multiplier is maintained at or around a target gain value. The gain may be adjusted upwardly or downwardly based on a comparison between the electron flux of an electron emissive surface relatively early in the electron multiplication chain, and the electron flux of an electron emissive surface relatively late in the electron multiplication chain. In some embodiments, the electron flux of an electron emissive surface relatively late in the electron multiplication chain is replaced by the electron flux of a collector anode. The comparison may be achieved by periodically measuring electrical current through the relevant electron emissive surface or anode, and generating a current ratio. Where required, the electron multiplier gain is adjusted by adjusting the voltage bias applied to the multiplier.

. Accordingly, in a first aspect the present invention provides a method for determining a performance parameter of an electron multiplier having a series of electron emissive surfaces forming electron multiplication chain, the method comprising comparing a first electron flux of a first electron emissive surface of the electron multiplication chain with a second electron flux of a second electron emissive surface of the electron multiplication chain, or of an electron collector of the electron multiplier

. When new, the gain of the multiplier may be set to a required target value. The current ratio at that gain is measured, inferred or assumed to be a certain value. The current ratio at the target gain may be used as a comparator current ratio against which later-measured current ratios are compared. Where the later-measured current ratio shows a significant deviation above or below the comparator ratio, the voltage bias applied to the multiplier is adjusted so as to bring the ratio closer to the comparator ratio and in that process return the multiplier to the target gain.

. Without wishing to be limited by theory in any way, it is proposed that changes in current ratio described above are reflective of performance changes in multiplier over time due to ageing, "burn in" or some other factor. Thus, current ratio may be continuously or semi-continuously monitored with the aim of adjusting multiplier gain in real time so as to maintain the gain at or about the same level when the multiplier was new.

. It is not necessary that the comparator current ratio be set when the multiplier is new. The comparator current ratio may be determined at any point in time after the first use, so long as the determination is made when the multiplier is set to a target gain value. The present invention will nevertheless be operable so as to maintain the gain at or around the target gain value.

. The comparator current ratio may be set by non-empirical methods. For example, for a given model of electron multiplier, a table of current ratios and gain may be generated. The table may show the relationship between current ratio and gain for multiplier after various number of hours of operation. The table may be hardcopy or electronic.

. According to the present invention, the comparator current ratio, or a later test current ratio is generated by reference to the electron fluxes of two points in the electron multiplier. As will be appreciated, electron flux (being the flow of electrons) is reflected in an electrical current measured at each of the two points.

. The first of the two points is an electron emissive surface that is relatively early in the electron multiplication chain, and the second of the two points is relatively late in the electron chain. Without wishing to be limited by theory in any way, it is proposed that comparison of fluxes at the two points is informative because an early electron emissive surface ages little over time given the relatively low electron fluxes experienced. For example, where each dynode of a discrete dynode multiplier has a modest yield of two, a particle impacting the first dynode causes the release of two secondary electrons, those two electrons impact the second dynode to release four electrons, those four electrons impact the third dynode to release eight electrons, those eight electrons impact the fourth dynode to release sixteen electrons, those sixteen electrons impact the fifth dynode to release thirty-two electrons. As will be appreciated, thirty-two electrons is not a significant electron flux and accordingly, over time only a low amount of dynode degradation will be occasioned.

. However, given the geometric increase in electrons down the multiplication chain, later dynodes will be exposed to very significant electron flux. High levels of flux will age the dynode relatively rapidly, and therefore have a significant negative effect on the overall gain of the multiplier over time. The relatively slowly ageing earlier dynodes therefore provide a useful benchmark against which performance effects arising from rapidly ageing later dynodes may be assessed.

. When selecting an early electron emissive surface in the electron multiplication chain, regard may be had to any negative effect of intermittently sampling the electron flux (i.e. current) at that point in the multiplier. In the example referred to above, the fifth dynode was selected on the basis that the dynode experiences a reasonable level of flux such that sensitivity of the detector of which the multiplier is a part is not significantly impacted.

. At the extreme, the earliest (i.e. first) dynode may be selected. However, selection of the first dynode may result in significant negative impact on sensitivity given the low electron flux (i.e. two electrons in the example discussed above). Intermittent sampling of electron flux at the first dynode may "rob" the multiplier of precious signal given that only two electrons are present. The situation would be improved at the third dynode because four electrons are available for sampling, however it would be expected that sampling would nevertheless negatively impact sensitivity. Thus, while the selected dynode should be early in the electron multiplication chain, it should not be too early.

. The example above is predicated on each of the dynodes having a yield of two electrons (i.e. one impacting electron triggers the release of on average two secondary electrons). Higher yielding dynodes may direct the selection of a dynode earlier than the fifth dynode. For example, where the yield of each dynode is 10 the second or third dynode may be selected. Conversely, for a yield of 1.5 the seventh or eighth dynode may be selected.

. Another consideration in the selection of the early dynode may be the resilience to ageing for the dynode material in question. Where a dynode material is relatively resistant to ageing, then a dynode having a higher electron flux may be selected, with the attendant advantage of lessening the negative impact on sensitivity. In the example above where the fifth dynode was selected as the early electron emissive surface, use of a dynode material having a higher resilience to ageing may have allowed for the sixth dynode to be selected.

. In some embodiments of the invention, an early dynode may be one that typically emits between about 10¹ to 10³ electrons is a useful early dynode?

. As to the selection of the later dynode, all that is required is that the later dynode ages more rapidly than the earlier dynode. Thus, is the example referred to above where the fifth dynode is selected, the later dynode may the sixth dynode given the higher flux experienced by the latter dynode will lead to more rapid ageing than the former. While the sixth dynode may be operable to some extent, more reliable results may be expected from the seventh, eighth, ninth or a later dynode. A current ratio obtained from the fifth and sixth dynodes may not be of a significant quantum and therefore lead to less accurate adjustments of gain to account for the effects of multiplier ageing. A higher ratio may be more likely to reliably reflect a change in gain due to ageing (or any other factor), and therefore allow for more accurate adjustment of gain to achieve a target gain. Thus, the later electron emissive surface may be two, three, four, five or more dynodes down the multiplication chain, counted from the earlier dynode.

. The discussion above on early and late dynode selection applies equally to continuous dynode electron multipliers, except that the early and later sites in the multiplication chain substitute for the earlier and later dynodes.

. In the present invention, the later electron emissive surface may be replaced by an electron collector forming part of a detector that incorporates the electron multiplier. As will be appreciated, the function of the collector (which is an anode) is not to emit secondary electrons but instead to collect the secondary electrons emitted by the terminal electron emissive surface of the electron multiplier. In that function, the electron flux of the collector can be considered as a proxy or as an approximation of the electron flux of the terminal electron emissive surface.

. As reflected in the accompanying claims, the present invention may be implemented as a method, or as a product (such as an electron multiplier configured to operate according to the method).

. Reference is made to FIG. 1, showing an embodiment of a preferred electron multiplier of the present invention. Discussion of the construction and operation of the electron multiplier illuminates features of the prevent method.

. As drawn in FIG. 1, there is shown a discrete dynode electron multiplier comprising a series of dynodes (D1 through D_{N}). An input particle is caused to impact D1. Where the input particle is not an electron, D1 can be considered to function as a conversion dynode in that it converts the particle (such as an ion) into an electron signal. In the function of conversion dynode, D1 may function also to amplify the incoming signal where the impact of a single particle leads to the release of more than one electron. The electron multiplication chain formed by D1 through D_{N} has a voltage bias applied thereto by the power supply (10). A series of resistors (R1 through R_{N-1}) are inserted between dynodes to form a voltage divider. The applied voltages cause secondary electrons (indicated by the arrowed semi-circular lines) to travel down the electron multiplication chain formed by D1 through D_{N}. A collector anode is disposed proximal to the terminal dynode (DN) to collect secondary electrons emitted by that dynode. The electron multiplier, collector anode, and amplifier together form a particle detector. The output of the particle detector is essentially an amplified signal reflecting the impact of the particle initially at D1.

. The arrangement described above is conventional in the art. The present invention provides additional hardware elements and additional method steps as described below.

. Staying with FIG. 1, the invention as drawn utilises D5 as the early electron emissive surface, and the terminal dynode (D_{N}) as the later electron emissive surface. In order to measure electron flux through those dynodes, processor-controllable multiplexing switches (15) and (20) are provided to divert electron flux out of the electron multiplication chain and into a current measuring devices (25) and (30), respectively. The switches (15) and (20) are normally set so as to not divert electron flux. Periodically, electron flux for each of D5 and D_{N} is sampled by setting the switches (25) and (30) to divert current to current measuring devices (25) and (30). As an alternative to the use of any switch, a beam splitting dynode may be used to continuously sample the electron beam and in which case the electron beam continues down the multiplier. A switching electrode to steer the electron beam is a further possible alternative.

. The measured currents are sent in analogue or digital form to the digital processor (35). Processor (35) is in operable connection to memory module (40) having stored therein program instructions (45) configured to accept the measured currents as input and mathematically generate a current ratio therefrom.

. The power supply (10) is processor-controllable in that the processor (35) is able to, under program instructions (45) modulate the output voltage (i.e. closer to or away from 0 volts, taken as ground or a reference voltage). Modulation of output voltage increases or decreases the electron multiplier gain.

. Memory module (40) holds a previously stored comparator ratio determined by reference to currents measured by devices (25) and (30) when the electron multiplier was new.

. In subsequent operation of the electron multiplier, program instructions (45) direct switches (15) and (20) to intermittently open and close so as to sample current from D5 and D_{N}. The sampled currents are input by program instructions (45), the instructions generating a current ratio. The generated current ratio is compared with the comparator current ratio stored in memory module (45). A ratio lower than the stored comparator ratio is indicative that the electron multiplier has aged, and gain therefore decreased. In that scenario, the bias voltage applied by the power supply (10) is increased (i.e. moved further away from zero), so as to increase the voltage applied to the electron multiplier. Under the direction of program instructions (45), the currents of D5 and D_{N} are continuously sampled as the voltage is increased, and current ratio generated therefrom continuously updated. Once an updated current ratio is equal or about equal to the comparator current ratio, program instructions (45) instruct the power supply (10) stop increasing voltage and to hold the voltage at that output when the comparator current ratio was reached.

. Program instructions (45) direct further sampling of the D5 and D_{N} currents and again modulates the voltage output by power supply (10) when the current ratio departs from the comparator current ratio. By this continuous monitoring of current ratio, the gain of the electron multiplier can be maintained at or above a target level.

. In a simple method for determining current ratio, the electron multiplier may be configured so as to fix the voltage over the first, say, 10 multiplication stages. That may be achieved by, for example, the use of Zener diodes to fix the voltage over the first 10 stages. As voltage is increased, the voltage difference between adjacent dynodes remains substantially the same. Given that the gain over the first 10 stages is therefore fixed, determining the current ratio is a simple matter. A current "pickoff point" may be provided at the eighth stage, for example, with the current at the eighth stage and the tenth stage being used to generate a ratio.

. As an alternative to the direct use of a simple current ratio, a more complex method may be implemented whereby a gain curve for the output at the fifth stage (or another opportune multiplication stage, such as the third, fourth, sixth, or seventh stage) may be generated. That measurement may be performed during detector gain calibration, and informs how the gain across the first five multiplication stages changes with applied voltage. That information is in turn used to adjust the target ratio, to factor that out. That approach is applicable when the dynode-dynode voltage (and gain) changes across the front end (such as where a resistor string is used rather than Zener diodes). The remainder of the architecture is identical, including use of the same signal pick-off points.

. The present invention is applicable also to electron multipliers that have a single electron emissive surface divided into electron impact sites. An example is shown at FIG. 3 showing a multiplier formed from a curved channel, the curve being shaped such that secondary electrons travel to an opposing internal surface of the channel and along toward the channel terminus. In this embodiment, the switches (15) and (20) do not function as multiplexors (as in the discrete dynode embodiment), but instead assume either an opened or closed state. The switches (15) and (20) are normally closed, and so electrons are not diverted from the channel to the current measuring devices (25) and (30). To sample current, the switches (15) and (20) are opened, such that electrons in the respective regions of the channel travel toward ground or a lower reference voltage and accordingly pass through the current measuring devices (25) and (30).

. In embodiments of the invention reliant on software program instructions, a processor is required to execute those instructions. It is contemplated that a substantially self-contained device may be provided where the processor is provided by a microcontroller, with the program instructions being stored in transitory or non-transitory memory of the microcontroller in the form of firmware. The self-contained device may comprise also any switching means or other means achieving the same outcome to sample current from selected electron emissive surfaces or the collector anode, in addition to current sensing devices. Power to the processor may be provided by an on-board battery.

. In other embodiments, a system is provided whereby some elements of the invention are provided in unitary form with the basic electron multiplier hardware, while the processor and program instructions are located remotely. For example, the processor and program instructions may be provided by an instrument (such as a mass spectrometer) in which the electron multiplier is operable. In another example, a personal computer holds the software instructions, the computer being in data communication with the electron multiplier. In some embodiments, the electron multiplier comprises at least any switching means, or other means for achieving the same outcome, and current measuring means.

. In one aspect, the invention is embodied in program instructions being stored in transitory or non-transitory memory. However implemented, the program instructions may be configured to execute the algorithm shown in flowchart form in FIG. 4. As will be noted, the algorithm executes as a loop. Although not shown in the flowchart, the loop is interruptible as required. The algorithm functions on the assumption that the current ratio decreases over time (which may or may not be a valid assumption depending on the application), and to return the ratio to a predetermined comparator ratio an increase in voltage bias applied to the electron multiplier is required.

. As will appreciated, the present invention provides in one aspect an electron multiplier that is automatically adjusted during operation so as to achieve a target gain. In that regard, the user is freed from the need to regularly manually adjust gain thereby saving time and consumables.

. As discussed in the Background section herein, users often set a multiplier gain unnecessarily high so as extend the period between which gain adjustment is performed. An electron multiplier according to the present invention may be continuously set to a gain that is just sufficient for the application to which it is put, thereby saving the electron emissive surfaces from degradation. The service life of the electron multiplier as a whole may be therefore extended.

. The present invention has been described mainly with reference to particle detectors incorporating discrete dynode multipliers, channel electron multipliers and microchannel plate multipliers. It is to be appreciated that the invention is not limited to any detector arrangement, and is applicable to time-of-flight (TOF) and dual mode detectors. In particular, dual mode detectors would particularly benefit from the present invention to remove differential drift. Detectors devised in the future are included in the ambit of the present specification.

. Similarly, while the present invention has been described primarily by reference to a detector of the type used in a mass spectrometer, it is to be appreciated that the invention is not so limited. In other applications the particle to be detected may not be an ion, and may be a neutral atom, a neutral molecule, or an electron. In any event, a detector surface is still provided upon which the particles impact.

. As will be appreciated by the skilled artisan, the present invention may be deployed in part or in whole through one or more processors that execute computer software, program codes, and/or instructions on a processor. The processor may be part of a server, client, network infrastructure, mobile computing platform, stationary computing platform, or other computing platform. A processor may be any kind of computational or processing device capable of executing program instructions, codes, binary instructions and the like. The processor may be or may include a signal processor, digital processor, embedded processor, microprocessor or any variant such as a coprocessor (math co-processor, graphic co-processor, communication co-processor and the like) and the like that may directly or indirectly facilitate execution of program code or program instructions stored thereon.

. In addition, the processor may enable execution of multiple programs, threads, and codes.

. The threads may be executed simultaneously to enhance the performance of the processor and to facilitate simultaneous operations of the application. By way of implementation, methods, program codes, program instructions and the like described herein may be implemented in one or more thread. The thread may spawn other threads that may have assigned priorities associated with them; the processor may execute these threads based on priority or any other order based on instructions provided in the program code. The processor may include memory that stores methods, codes, instructions and programs as described herein and elsewhere.

. Any processor or a mobile device or server may access a storage medium through an interface that may store methods, codes, and instructions as described herein and elsewhere. The storage medium associated with the processor for storing methods, programs, codes, program instructions or other type of instructions capable of being executed by the computing or processing device may include solid state memory and hard disk memory.

. A processor may include one or more cores that may enhance speed and performance of a multiprocessor. In some embodiments, the processor may be a dual core processor, quad core processors, other chip-level multiprocessor and the like that combine two or more independent cores (called a die).

. The methods and systems described herein may be deployed in part or in whole through one or more hardware components that execute software on a server, client, firewall, gateway, hub, router, or other such computer and/or networking hardware. The software program may be associated with a server that may include a file server, print server, domain server, internet server, intranet server and other variants such as secondary server, host server, distributed server and the like. The server may include one or more of memories, processors, computer readable media, storage media, ports (physical and virtual), communication devices, and interfaces capable of accessing other servers, clients, computers, and devices through a wired or a wireless medium, and the like. The methods, programs or codes as described herein and elsewhere may be executed by the server. In addition, other devices required for execution of methods as described in this application may be considered as a part of the infrastructure associated with the server.

. The server may provide an interface to other devices including, without limitation, clients, other servers, printers, database servers, print servers, file servers, communication servers, distributed servers and the like. Additionally, this coupling and/or connection may facilitate remote execution of program across the network. The networking of some or all of these devices may facilitate parallel processing of a program or method at one or more location without deviating from the scope of the invention. In addition, any of the devices attached to the server through an interface may include at least one storage medium capable of storing methods, programs, code and/or instructions. A central repository may provide program instructions to be executed on different devices. In this implementation, the remote repository may act as a storage medium for program code, instructions, and programs.

. The software program may be associated with a client that may include a file client, print client, domain client, internet client, intranet client and other variants such as secondary client, host client, distributed client and the like. The client may include one or more of memories, processors, computer readable media, storage media, ports (physical and virtual), communication devices, and interfaces capable of accessing other clients, servers, computers, and devices through a wired or a wireless medium, and the like. The methods, programs or codes as described herein and elsewhere may be executed by the client. In addition, other devices required for execution of methods as described in this application may be considered as a part of the infrastructure associated with the client.

. The client may provide an interface to other devices including, without limitation, servers, other clients, printers, database servers, print servers, file servers, communication servers, distributed servers and the like. Additionally, this coupling and/or connection may facilitate remote execution of program across the network. The networking of some or all of these devices may facilitate parallel processing of a program or method at one or more location without deviating from the scope of the invention. In addition, any of the devices attached to the client through an interface may include at least one storage medium capable of storing methods, programs, applications, code and/or instructions. A central repository may provide program instructions to be executed on different devices. In this implementation, the remote repository may act as a storage medium for program code, instructions, and programs.

. The methods and systems described herein may be deployed in part or in whole through network infrastructures. The network infrastructure may include elements such as computing devices, servers, routers, hubs, firewalls, clients, personal computers, communication devices, routing devices and other active and passive devices, modules and/or components as known in the art. The computing and/or non-computing device(s) associated with the network infrastructure may include, apart from other components, a storage medium. The processes, methods, program codes, instructions described herein and elsewhere may be executed by one or more of the network infrastructural elements.

. The methods, program codes, calculations, algorithms, and instructions described herein may be implemented on a cellular network having multiple cells. The cellular network may include mobile devices, cell sites, base stations, repeaters, antennas, towers, and the like. The cell network may be a GSM, GPRS, 3G, 4G, 5G, EVDO, mesh, or other network types.

. The methods, programs codes, calculations, algorithms and instructions described herein may be implemented on or through mobile devices. The mobile devices may include, cell phones, mobile personal digital assistants, laptops, palmtops, netbooks, pagers, electronic book readers and the like. These devices may include, apart from other components, a storage medium such as a flash memory, buffer, RAM, ROM and one or more computing devices. The computing devices associated with mobile devices may be enabled to execute program codes, methods, and instructions stored thereon.

. Alternatively, the mobile devices may be configured to execute instructions in collaboration with other devices. The mobile devices may communicate with base stations interfaced with servers and configured to execute program codes. The mobile devices may communicate on a peer-to-peer network, mesh network, or other communications network. The program code may be stored on the storage medium associated with the server and executed by a computing device embedded within the server. The base station may include a computing device and a storage medium. The storage device may store program codes and instructions executed by the computing devices associated with the base station.

. The computer software, program codes, and/or instructions may be stored and/or accessed on computer readable media that may include computer components, devices, and recording media that retain digital data used for computing for some interval of time; storage known as random access memory (RAM); mass storage typically for more permanent storage, such as optical discs, forms of magnetic storage like hard disks.

. The methods and systems described herein may transform physical and/or or intangible items from one state to another. The methods and systems described herein may also transform data representing physical and/or intangible items from one state to another.

. The elements described and depicted herein may imply logical boundaries between the elements. However, according to software or hardware engineering practices, the depicted elements and the functions thereof may be implemented on computers through computer executable media having a processor capable of executing program instructions stored thereon as a monolithic software structure, as standalone software modules, or as modules that employ external routines, code, services, and so forth, or any combination of these, and all such implementations may be within the scope of the present disclosure.

. Furthermore, the elements depicted may be implemented on a machine capable of executing program instructions. Thus, while the present descriptions set forth functional aspects of the disclosed systems, no particular arrangement of software for implementing these functional aspects should be inferred from these descriptions unless explicitly stated or otherwise clear from the context. Similarly, it will be appreciated that the various steps identified and described above may be varied, and that the order of steps may be adapted to particular applications of the techniques disclosed herein. All such variations and modifications are intended to fall within the scope of this disclosure. As such, the depiction and/or description of an order for various steps should not be understood to require a particular order of execution for those steps, unless required by a particular application, or explicitly stated or otherwise clear from the context.

. The methods and/or processes described above, and steps thereof, may be realised in hardware, software or any combination of hardware and software suitable for a particular application. The hardware may include a general purpose computer and/or dedicated computing device or specific computing device or particular aspect or component of a specific computing device. The processes may be realised in one or more microprocessors, microcontrollers, embedded microcontrollers, programmable digital signal processors or other programmable device, along with internal and/or external memory. The processes may also, or instead, be embodied in an application specific integrated circuit, a programmable gate array, programmable array logic, or any other device or combination of devices that may be configured to process electronic signals. It will further be appreciated that one or more of the processes may be realised as a computer executable code capable of being executed on a computer readable medium.

. The application software may be created using a structured programming language such as C, an object oriented programming language such as C++, or any other high-level or low-level programming language (including assembly languages, hardware description languages, and database programming languages and technologies) that may be stored, compiled or interpreted to run on one of the above devices, as well as heterogeneous combinations of processors, processor architectures, or combinations of different hardware and software, or any other machine capable of executing program instructions.

. Thus, in one aspect, each method described above, and combinations thereof may be embodied in computer executable code that, when executing on one or more computing devices, performs the steps thereof. In another aspect, the methods may be embodied in systems that perform the steps thereof, and may be distributed across devices in a number of ways, or all of the functionalities may be integrated into a dedicated, standalone device or other hardware. In another aspect, the means for performing the steps associated with the processes described above may include any of the hardware and/or software described above. All such permutations and combinations are intended to fall within the scope of the present disclosure.

. Any of the methods disclosed herein may be performed by application software executable on any past, present or future operating system of a processor-enabled device such as Windows^{™}, Linux^{™} Android^{™}, iOS^{™}, and the like. It will be appreciated that any software may be distributed across a number of devices or in a "software as a service" format, or "platform as a service" format whereby participants require only some computer-based means of engaging with the software.

. It will be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

. Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

. In the description provided herein, numerous specific details are set forth. However, it is understood that embodiments of the invention may be practiced without these specific details. In other instances, well-known methods, structures and techniques have not been shown in detail in order not to obscure an understanding of this description.

. Thus, while there has been described what are believed to be the preferred embodiments of the invention, those skilled in the art will recognize that other and further modifications may be made thereto without departing from the spirit of the invention, and it is intended to claim all such changes and modifications as fall within the scope of the invention. Functionality may be added or deleted from the diagrams and operations may be interchanged among functional blocks. Steps may be added or deleted to methods described within the scope of the present invention.

. Although the invention has been described with reference to specific examples, it will be appreciated by those skilled in the art that the invention may be embodied in many other forms.

### Inventive Clauses

1. A method for determining a performance parameter of an electron multiplier having a series of electron emissive surfaces forming electron multiplication chain, the method comprising comparing a first electron flux of a first electron emissive surface of the electron multiplication chain with a second electron flux of a second electron emissive surface of the electron multiplication chain, or of an electron collector of the electron multiplier.
2. The method of clause 1, wherein the first and the second electron emissive surfaces are each a discrete electron emissive surface.
3. The method of clause 2, wherein each of the discrete electron emissive surfaces is a dynode of a discrete dynode electron multiplier.
4. The method of clause 1, wherein the first and the second electron emissive surfaces are provided by a single electron emissive surface.
5. The method of clause 4, wherein the single electron emissive surface is a channel of a channel electron multiplier, or a plate of a microchannel plate electron multiplier.
6. The method of any one of clauses 1 to 5, wherein the first electron emissive surface is earlier in the electron multiplication chain than the second electron emissive surface.
7. The method of any one of clauses 1 to 6, wherein the first electron emissive surface is less susceptible to electron flux-mediated gain degradation than the second electron emissive surface.
8. The method of any one of clauses 1 to 7, wherein the first electron emissive surface carries less electron flux than the second electron emissive surface.
9. The method of any one of clauses 1 to 7, wherein the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than the second electron emissive surface.
10. The method of any one of clauses 1 to 9, wherein the second electron flux is determined at the electron collector and the first electron emissive surface carries less electron flux than a terminal electron emissive surface of the electron multiplication chain.
11. The method of any one of clauses 1 to 10, wherein the second electron flux is determined at the electron collector and the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than a terminal electron emissive surface of the electron multiplication chain.
12. The method of any one of clauses 1 to 11, wherein the first electron emissive surface is within the first 75%, 70%, 65%, 60%, *55%, 50%,* 45%, 40%, 35%, 30%, or 25% of the electron multiplication chain.
13. The method of any one of clauses 1 to 12, wherein the first electron emissive surface is not within the first 5%, 10%, 15%, 20% or 25% of the electron multiplication chain.
14. The method of any one of clauses 1, 2, 3, and 6 to 13, wherein the electron multiplier comprises discrete electron emissive surfaces, the first electron emissive surface is the third, fourth, fifth, sixth or seventh electron emissive surface of the electron multiplication chain.
15. The method of any one of clauses 1, 2, 3, and 6 to 13, wherein the electron multiplier comprises discrete electron emissive surfaces, the first electron emissive surface is the fourth, fifth, or sixth electron emissive surface of the electron multiplication chain.
16. The method of any one of clauses 1, 2, 3, and 6 to 13, wherein the electron multiplier comprises discrete electron emissive surfaces, the first electron emissive surface is the fifth electron emissive surface of the electron multiplication chain.
17. The method of any one of clauses 1, 2, 3, and 6 to 13, wherein the electron multiplier comprises discrete electron emissive surfaces, the first electron emissive surface and the second electron emissive surface, or the first electron emissive surface and the electron collector, are separated by at least 2, 3, 4, or 5 intervening electron emissive surfaces.
18. The method of any one of clauses 1, 4 and 5, wherein the electron multiplier comprises a single electron emissive surface having a series of electron emissive sites which together form the electron multiplication chain, and the first electron emissive surface is the third, fourth, fifth, sixth or seventh electron emissive site of the electron multiplication chain.
19. The method of any one of clauses 1, 4 and 5, wherein the electron multiplier comprises a single electron emissive surface having a series of electron emissive sites which together form the electron multiplication chain, and the first electron emissive surface is the fourth, fifth, or sixth electron emissive site of the electron multiplication chain.
20. The method of any one of clauses 1, 4 and 5, wherein the electron multiplier comprises a single electron emissive surface having a series of electron emissive sites which together form the electron multiplication chain, and the first electron emissive surface is the fifth electron emissive site of the electron multiplication chain.
21. The method of any one of clauses 1, 4 and 5, wherein the electron multiplier comprises a single electron emissive surface having a series of electron emissive sites which together form the electron multiplication chain, the first electron emissive site and the second electron emissive site, or the first electron emissive site and the electron collector, are separated by at least 2, 3, or 4 intervening electron emissive sites.
22. The method of any one of clauses 1 to 21, wherein the first and second electron fluxes are compared by way of (i) an electrical current measurement circuit and then comparing the determined currents, or (ii) an electrical current comparison circuit.
23. The method of any one of clauses 1 to 22, wherein the first and second electron fluxes are each determined at the same time point, or within a time period.
24. The method of clause 23, wherein the first and second electron fluxes are determined intermittently over a period of electron multiplier operation.
25. The method of clause 24, wherein the period of electron multiplier operation is equal to or greater than about 1 sec, 5 sec, 10 sec, 30 sec, 1 min, 5 min, 10 min, 20 min, 30 min, 40 min, 50 min or 1 hr.
26. The method of any one of clauses 1 to 25, wherein the first and second electron fluxes are determined according to a sampling rate.
27. The method of clause 26, wherein the sampling rate is equal to or less than about 1 Hz, 0.1 Hz or about 0.01 Hz.
28. The method of clause 26 or clause 27, wherein the sampling rate is equal to or greater than about 0.1 Hz, 0.2 Hz, 0.3 Hz, 0.4 Hz, 0.5 Hz, 0.6 Hz, 0.7 Hz, 0.8 Hz, 0.9 Hz, or 1 Hz.
29. The method of any one of clauses 26 to 28, wherein the sampling rate is between about 0.3 Hz and 0.01 Hz.
30. The method of any one of clauses 1 to 30, wherein the performance parameter is indicative of gain of the electron multiplier.
31. The method of any one of clauses 1 to 30, wherein the step of comparing comprises a mathematical operation utilising the determined first and second electron fluxes.
32. The method of any one of clauses 1 to 31, wherein the mathematical operation comprises the generation of a ratio, a multiple, a quotient, or a difference.
33. A method of operating an electron multiplier, the method comprising:
   determining a performance parameter of the electron multiplier according to the method of any one of clauses 1 to 32, comparing the determined performance parameter to a predetermined value or a predetermined range for the performance parameter, and
   where the determined performance parameter is not the predetermined value or is outside the predetermined range for the performance parameter, altering an operating parameter of the electron multiplier such that the determined performance parameter is the predetermined value or is inside the predetermined range for the performance parameter.
34. The method of clause 33, wherein the operating parameter is a voltage bias applied to the electron multiplier.
35. The method of clause 33 or clause 34 implemented so as to continuously monitor the performance parameter and as required alter the operating parameter of the electron multiplier, wherein the steps of determining, comparing and altering are sequentially executed multiple times over a time period.
36. The method of clause 35, wherein the performance parameter is electron multiplier gain, and the gain of the electron multiplier is maintained at a predetermined gain or with a predetermined gain range over a time period.
37. An electron multiplier or an electron multiplication system having a series of electron emissive surfaces forming electron multiplication chain, the electron multiplier method comprising circuitry and optionally processor-executable program instructions configured to compare a first electron flux of a first electron emissive surface of the electron multiplication chain with a second electron flux of a second electron emissive surface of the electron multiplication chain, or of an electron collector of the electron multiplier.
38. The electron multiplier or electron multiplication system of clause 37, wherein the first and the second electron emissive surfaces are each a discrete electron emissive surface.
39. The electron multiplier or electron multiplication system of clause 38, wherein each of the discrete electron emissive surfaces is a dynode of a discrete dynode electron multiplier.
40. The electron multiplier or electron multiplication system of clause 37, wherein the first and the second electron emissive surfaces are provided by a single electron emissive surface.
41. The electron multiplier or electron multiplication system of clause 40, wherein the single electron emissive surface is a channel of a channel electron multiplier, or a plate of a microchannel plate electron multiplier.
42. The electron multiplier or electron multiplication system of any one of clauses 37 to 41, wherein the first electron emissive surface is earlier in the electron multiplication chain than the second electron emissive surface.
43. The electron multiplier or electron multiplication system of any one of clauses 37 to 42, wherein the first electron emissive surface is less susceptible to electron flux-mediated gain degradation than the second electron emissive surface.
44. The electron multiplier or electron multiplication system of any one of clauses 37 to 43, wherein the first electron emissive surface carries less electron flux than the second electron emissive surface.
45. The electron multiplier or electron multiplication system of any one of clauses 37 to 43, wherein the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than the second electron emissive surface.
46. The electron multiplier or electron multiplication system of any one of clauses 37 to 45, wherein the second electron flux is determined at the electron collector and the first electron emissive surface carries less electron flux than a terminal electron emissive surface of the electron multiplication chain.
47. The electron multiplier or electron multiplication system of any one of clauses 37 to 461, wherein the second electron flux is determined at the electron collector and the first electron emissive surface carries at least about 2, 3, 4, 5, 6, 7, 8, 9, 10, 20, 30, 40, 50, 60, 70, 80, 90, 100, 1000, 2000, 3000, 4000, 5000, 6000, 7000, 8000, 9000, 10000, 20000, 30000, 40000, 50000, 60000, 70000, 80000, 90000, 100000, 200000, 300000, 400000, 500000, 60000, 700000, 800000, 900000 or 1000000 less electron flux than a terminal electron emissive surface of the electron multiplication chain.
48. The electron multiplier or electron multiplication system of any one of any one of clauses 37 to 47, wherein the first electron emissive surface is within the first 75%, 70%, 65%, 60%, 55%, 50%, 45%, 40%, 35%, 30%, or 25% of the electron multiplication chain.
49. The electron multiplier or electron multiplication system of any one of clauses 37 to 48, wherein the first electron emissive surface is not within the first 5%, 10%, 15%, 20% or 25% of the electron multiplication chain.
50. The electron multiplier or electron multiplication system of any one of clauses 37, 38, 39, and 42 to 49, wherein the electron multiplier comprises discrete electron emissive surfaces, the first electron emissive surface is the third, fourth, fifth, sixth or seventh electron emissive surface of the electron multiplication chain.
51. The electron multiplier or electron multiplication system of any one of clauses 37, 38, 39, and 42 to 49, wherein the electron multiplier comprises discrete electron emissive surfaces, the first electron emissive surface is the fourth, fifth, or sixth electron emissive surface of the electron multiplication chain.
52. The electron multiplier or electron multiplication system of any one of clauses 37, 38, 39, and 42 to 49, wherein the electron multiplier comprises discrete electron emissive surfaces, the first electron emissive surface is the fifth electron emissive surface of the electron multiplication chain.
53. The electron multiplier or electron multiplication system of any one of clauses 37, 38, 39, and 42 to 49, wherein the electron multiplier comprises discrete electron emissive surfaces, the first electron emissive surface and the second electron emissive surface, or the first electron emissive surface and the electron collector, are separated by at least 2, 3, 4, or 5 intervening electron emissive surfaces.
54. The electron multiplier or electron multiplication system of any one of clauses 37, 40 and 41, wherein the electron multiplier comprises a single electron emissive surface having a series of electron emissive sites which together form the electron multiplication chain, and the first electron emissive surface is the third, fourth, fifth, sixth or seventh electron emissive site of the electron multiplication chain.
55. The electron multiplier or electron multiplication system of any one of clauses 37, 40 and 41, wherein the electron multiplier comprises a single electron emissive surface having a series of electron emissive sites which together form the electron multiplication chain, and the first electron emissive surface is the fourth, fifth, or sixth electron emissive site of the electron multiplication chain.
56. The electron multiplier or electron multiplication system of any one of clauses 37, 40 and 41, wherein the electron multiplier comprises a single electron emissive surface having a series of electron emissive sites which together form the electron multiplication chain, and the first electron emissive surface is the fifth electron emissive site of the electron multiplication chain.
57. The electron multiplier or electron multiplication system of any one of clauses 37, 40 and 41, wherein the electron multiplier comprises a single electron emissive surface having a series of electron emissive sites which together form the electron multiplication chain, the first electron emissive site and the second electron emissive site, or the first electron emissive site and the electron collector, are separated by at least 2, 3, or 4 intervening electron emissive sites.
58. The electron multiplier or electron multiplication system of any one of clauses 37 to 57, wherein the circuitry and optionally the program instructions compares the first and second electron fluxes at least in part by (i) an electrical current measurement circuit and then comparing the measured currents by way of the program instructions, or (ii) an electrical current comparison circuit.
59. The electron multiplier or electron multiplication system of any one of clauses 37 to 58, wherein the circuitry and optionally the program instructions is/are configured to determine the first and second electron fluxes at the same time point, or within a time period.
60. The electron multiplier or electron multiplication system of clause 59, wherein the circuitry and optionally the program instructions is/are configured to determine first and second electron fluxes are determined intermittently over a period of electron multiplier operation.
61. The electron multiplier or electron multiplication system of clause 60, wherein the period of electron multiplier operation is equal to or greater than about 1 sec, 5 sec, 10 sec, 30 sec, 1 min, 5 min, 10 min, 20 min, 30 min, 40 min, 50 min or 1 hr.
62. The electron multiplier or electron multiplication system of any one of clauses 37 to 61, wherein the circuitry and optionally the program instructions is/are configured such that the first and second electron fluxes are determined according to a sampling rate.
63. The electron multiplier or electron multiplication system of clause 62, wherein the sampling rate is equal to or less than about 1 Hz, 0.1 Hz or about 0.01 Hz.
64. The electron multiplier or electron multiplication system of clause 62 or clause 63, wherein the sampling rate is equal to or greater than about 0.1 Hz, 0.2 Hz, 0.3 Hz, 0.4 Hz, 0.5 Hz, 0.6 Hz, 0.7 Hz, 0.8 Hz, 0.9 Hz, or 1 Hz.
65. The electron multiplier or electron multiplication system of any one of clauses 62 to 64, wherein the sampling rate is between about 0.3 Hz and 0.01 Hz.
66. The electron multiplier or electron multiplication system of any one of clauses 37 to 65, wherein the performance parameter is indicative of a gain of the electron multiplier.
67. The electron multiplier or electron multiplication system of any one of clauses 37 to 66 wherein the circuitry and optionally program instructions is/are configured to:
   determine a performance parameter of the electron multiplier,
   compare the determined performance parameter to a predetermined value or a predetermined range for the performance parameter, and
   where the determined performance parameter is not the predetermined value or is outside the predetermined range for the performance parameter, alter an operating parameter of the electron multiplier such that the determined performance parameter is the predetermined value or is inside the predetermined range for the performance parameter.
68. The electron multiplier or electron multiplication system of clause 67, wherein the operating parameter is a voltage bias applied to the electron multiplier.
69. The electron multiplier or electron multiplication system of any one of clauses 37 to 68 wherein the circuitry and optionally the program instructions is/are configured to continuously monitor the performance parameter and as required alter the operating parameter of the electron multiplier, wherein the steps of determining, comparing and altering are sequentially executed multiple times over a time period.
70. The electron multiplier or electron multiplication system of clause 69, wherein the performance parameter is electron multiplier gain, and the gain of the electron multiplier is maintained at a predetermined gain or with a predetermined gain range over a time period.

## Claims

1. A method for determining a performance parameter of an electron multiplier having a series of electron emissive surfaces forming electron multiplication chain, the method comprising comparing a first electron flux of a first electron emissive surface of the electron multiplication chain with a second electron flux of a second electron emissive surface of the electron multiplication chain, or of an electron collector of the electron multiplier.

2. The method of claim 1, wherein the first and the second electron emissive surfaces each form part of a discrete dynode, continuous or microchannel plate multiplier.

3. The method of any one of claims 1 to 2, wherein the first electron emissive surface is earlier in the electron multiplication chain than the second electron emissive surface.

4. The method of any one of claims 1 to 3, wherein the first electron emissive surface is less susceptible to electron flux-mediated gain degradation than the second electron emissive surface.

5. The method of any one of claims 1 to 4, wherein the first electron emissive surface carries less electron flux than the second electron emissive surface.

6. The method of any one of claims 1 to 5, wherein the first electron emissive surface is within about the first 75%, 70%, 65%, 60%, 55%, 50%, 45%, 40%, 35%, 30%, or 25% of the electron multiplication chain.

7. The method of any one of claims 1 to 6, wherein the second electron emissive surface is within about the last 5%, 10%, 15%, 20% or 25% of the electron multiplication chain.

8. The method of any one of claims 1 to 7, wherein the first and second electron fluxes are compared by way of (i) an electrical current measurement circuit and then comparing the determined currents, or (ii) an electrical current comparison circuit.

9. The method of any one of claims 1 to 8, wherein the first and second electron fluxes are each determined at the same time point, or within a time period.

10. The method of claim 9, wherein the first and second electron fluxes are determined intermittently over a period of electron multiplier operation.

11. The method of any one of claims 1 to 10, wherein the performance parameter is indicative of gain of the electron multiplier.

12. The method of any one of claims 1 to 11, wherein the step of comparing comprises a mathematical operation utilising the determined first and second electron fluxes.

13. The method of any one of claims 1 to 12, wherein the mathematical operation comprises the generation of a ratio, a multiple, a quotient, or a difference.

14. A method of operating an electron multiplier, the method comprising:
determining a performance parameter of the electron multiplier according to the method of any one of claims 1 to 13,
comparing the determined performance parameter to a predetermined value or a predetermined range for the performance parameter, and
where the determined performance parameter is not the predetermined value or is outside the predetermined range for the performance parameter, altering an operating parameter of the electron multiplier such that the determined performance parameter is the predetermined value or is inside the predetermined range for the performance parameter.

15. The method of claim 13 or claim 14 implemented so as to continuously monitor the performance parameter and as required alter the operating parameter of the electron multiplier, wherein the steps of determining, comparing and altering are sequentially executed multiple times over a time period.

16. The method of claim 15, wherein the performance parameter is electron multiplier gain, and the gain of the electron multiplier is maintained at a predetermined gain or with a predetermined gain range over a time period.

17. An electron multiplier or an electron multiplication system having a series of electron emissive surfaces forming electron multiplication chain, the electron multiplier method comprising circuitry and optionally processor-executable program instructions configured according to the method of any claims 1 to 16.
